# EUROPEAN PATENT APPLICATION

(11) **EP 4 654 250 A1**
(43) Date of publication of application: **26.11.2025**
(21) Application number: 23917630.8
(22) Date of filing: 09.11.2023
(51) Int. Cl.: H01L 21/304, H01L 21/027, H01L 21/306

(54) **SUBSTRATE TREATMENT DEVICE AND SUBSTRATE TREATMENT METHOD**

(30) Priority: 19.01.2023 JP 2023006434; 19.09.2023 JP 2023150861
(71) Applicant: SCREEN Holdings Co., Ltd., Kyoto-shi, Kyoto 602-8585 (JP)
(72) Inventor: IWAO, Michinori, Kyoto-shi, Kyoto 602-8585 (JP); KAMON, Hiroaki, Kyoto-shi, Kyoto 602-8585 (JP); IWAHATA, Shota, Kyoto-shi, Kyoto 602-8585 (JP)
(74) Representative: Kilian Kilian & Partner mbB
(86) International application number: PCT/JP2023/040418
(87) International publication number: WO 2024/154418

(57) **Abstract**

Uniform substrate treatment is performed using electrolytic sulfuric acid. A substrate treatment device includes: a substrate treatment unit that treats a substrate using a treatment liquid containing electrolytic sulfuric acid; a supply tank that stores the treatment liquid to be supplied to the substrate treatment unit; a generation unit that generates the treatment liquid by electrolysis and supplies the generated treatment liquid to the supply tank; a collection unit that collects a supplied liquid that is the treatment liquid supplied to the substrate treatment unit and supplies the supplied liquid to the generation unit; a circulation path that returns the treatment liquid supplied from the supply tank to the supply tank; a first branch path that branches from the circulation path and supplies the treatment liquid to the substrate treatment unit; and a temperature increasing unit that increases a temperature of the supplied liquid.

## Description

### TECHNICAL FIELD

The technology disclosed in the present specification relates to a substrate treatment technology. Examples of a substrate to be treated include a semiconductor wafer, a glass substrate for a liquid crystal display device, a substrate for a flat panel display (FPD) such as an organic electroluminescence (EL) display device, a substrate for an optical disk, a substrate for a magnetic disk, a substrate for a magneto-optical disk, a glass substrate for a photomask, a ceramic substrate, a substrate for a field emission display (FED), a substrate for a solar cell, and the like.

### BACKGROUND ART

In related art, a mixed solution of sulfuric acid and hydrogen peroxide water (SPM), or the like, has been used as a treatment liquid for substrate treatment (see, for example, Patent Document 1). The SPM is a treatment liquid that generates oxidizing force by mixing hydrogen peroxide water with sulfuric acid and is mainly used for substrate treatment such as removal of a resist formed on an upper surface of a substrate.

### PRIOR ART DOCUMENT

### PATENT DOCUMENT

Patent Document 1: Japanese Patent Application Laid-Open No. 2018-163977

### SUMMARY

### PROBLEM TO BE SOLVED BY THE INVENTION

On the other hand, instead of using an SPM that generates a large amount of waste liquid as a treatment liquid, electrolytic sulfuric acid can be used as a treatment liquid for substrate treatment.

However, in a case where the sequentially generated electrolytic sulfuric acid is used as it is for substrate treatment, flow of the electrolytic sulfuric acid may be delayed when substrate treatment is interrupted, which may lead to non-uniformity of a liquid temperature or concentration of the electrolytic sulfuric acid.

The technology disclosed in the present specification has been made in view of the problem as described above, and is a technology for performing uniform substrate treatment using electrolytic sulfuric acid.

### MEANS TO SOLVE THE PROBLEM

A substrate treatment device according to a first aspect of the technology disclosed in the present specification includes: a substrate treatment unit that treats a substrate using a treatment liquid containing electrolytic sulfuric acid; a supply tank that stores the treatment liquid to be supplied to the substrate treatment unit; a generation unit that generates the treatment liquid by electrolysis and supplies the generated treatment liquid to the supply tank; a collection unit that collects a supplied liquid that is the treatment liquid having been supplied to the substrate treatment unit and supplies the supplied liquid to the generation unit; a circulation path that returns the treatment liquid supplied from the supply tank to the supply tank; a first branch path that branches from the circulation path and supplies the treatment liquid to the substrate treatment unit; and a temperature increasing unit that increases a temperature of the supplied liquid.

A substrate treatment device according to a second aspect of the technology disclosed in the present specification relates to the substrate treatment device according to the first aspect, and the temperature increasing unit is provided in the first branch path.

A substrate treatment device according to a third aspect of the technology disclosed in the present specification relates to the substrate treatment device according to the second aspect, and further includes a second branch path that branches from the first branch path and supplies the supplied liquid to the collection unit, and the temperature increasing unit is provided upstream of a point at which the second branch path branches, in the first branch path.

A substrate treatment device according to a fourth aspect of the technology disclosed in the present specification relates to the substrate treatment device according to any one of the first to third aspects, and the generation unit includes a first temperature adjustment unit that adjusts temperatures of the supplied liquid and the generated treatment liquid to an electrolysis temperature that is a temperature for generating the treatment liquid by electrolysis.

A substrate treatment device according to a fifth aspect of the technology disclosed in the present specification relates to the substrate treatment device according to the fourth aspect, and further includes a second temperature adjustment unit that adjusts the temperature of the treatment liquid to a circulation temperature that is higher than the electrolysis temperature in the circulation path, and the temperature increasing unit increases the temperature of the supplied liquid to a temperature higher than the circulation temperature.

A substrate treatment device according to a sixth aspect of the technology disclosed in the present specification relates to the substrate treatment device according to any one of the first to fifth aspects, and further includes an electrolytic cell that generates the treatment liquid by electrolysis in the circulation path.

A substrate treatment device according to a seventh aspect of the technology disclosed in the present specification relates to the substrate treatment device according to any one of the first to sixth aspects, the substrate treatment unit includes a substrate holding unit that holds the substrate, and the temperature increasing unit is provided in the substrate holding unit.

A substrate treatment device according to an eighth aspect of the technology disclosed in the present specification relates to the substrate treatment device according to any one of the first to seventh aspects, in which the collection unit collects the treatment liquid before the temperature of the treatment liquid is increased by the temperature increasing unit.

A substrate treatment method as a ninth aspect of the technology disclosed in the present specification is a substrate treatment method of treating a substrate using a treatment liquid containing electrolytic sulfuric acid, the substrate treatment method including: a step of supplying the treatment liquid stored in a supply tank to a substrate treatment unit that treats the substrate using the treatment liquid; a step of increasing a temperature of a supplied liquid that is the treatment liquid having been supplied to the substrate treatment unit; a step of collecting the supplied liquid and supplying the supplied liquid to a generation unit; and a step of generating the treatment liquid from a liquid containing the supplied liquid by electrolysis in the generation unit and supplying said generated treatment liquid to the supply tank, and the step of supplying the treatment liquid to the substrate treatment unit includes a step of supplying the treatment liquid to the substrate treatment unit by supplying the treatment liquid to a circulation path that returns the treatment liquid supplied from the supply tank to the supply tank and a first branch path that branches from the circulation path and supplies the treatment liquid to the substrate treatment unit.

### EFFECTS OF THE INVENTION

According to at least the first and ninth aspects of the technology disclosed in the present specification, a treatment liquid is supplied from a branch path to a substrate treatment unit during substrate treatment while being circulated in a circulation path, so that the treatment liquid can be used for substrate treatment at necessary timing while being maintained in a uniform state. It is therefore possible to perform uniform substrate treatment.

Further, objects, features, aspects, and advantages relating to the technique disclosed in the present specification will be more apparent from the following detailed description and the accompanying drawings.

### BRIEF DESCRIPTION OF DRAWINGS

[FIG. 1] is a view illustrating an example of a configuration of a substrate treatment device according to an embodiment.
[FIG. 2] is a view conceptually illustrating an example of a configuration of a control unit for which an example is illustrated in FIG. 1.
[FIG. 3] is a view schematically illustrating an example of a treatment unit and related components in the substrate treatment device according to the embodiment.
[FIG. 4] is a cross-sectional view illustrating an example of an internal structure of a discharge nozzle.
[FIG. 5] is a view illustrating an example of a configuration of the substrate treatment device in a collection state of the discharge nozzle.
[FIG. 6] is a view illustrating an example of a configuration of the substrate treatment device in a discharge state of the discharge nozzle.
[FIG. 7] is a view illustrating an example of a configuration of the substrate treatment device according to the embodiment.
[FIG. 8] is a view illustrating an example of a configuration of the substrate treatment device in a circulation state of the discharge nozzle.
[FIG. 9] is a view illustrating an example of a configuration of the substrate treatment device in the collection state of the discharge nozzle.
[FIG. 10] is a view illustrating an example of a configuration of the substrate treatment device in the discharge state of the discharge nozzle.

### DESCRIPTION OF EMBODIMENTS

Hereinafter, embodiments will be described with reference to the accompanying drawings. In the following embodiments, detailed features, and the like, are also indicated for the description of the technology, but they are merely examples, and not all of them are necessarily essential features in order to enable the embodiments to be carried out.

Note that the drawings are schematically illustrated, and omission of a component, simplification of a configuration, or the like, is appropriately made in the drawings for convenience of description. In addition, a mutual relationship of sizes and positions of components, and the like, illustrated in different drawings is not necessarily accurately described, and can be appropriately changed. In addition, hatching may be applied to a drawing such as a plan view that is not a cross-sectional view in order to facilitate understanding of the content of the embodiments.

Furthermore, in the following description, similar components are denoted by the same reference numerals, and names and functions thereof are also similar. Thus, detailed description thereof may be omitted in order to avoid duplication.

In addition, in the description described in the present specification, in a case where a certain component is described as "comprising", "including", "having", or the like, the expression is not an exclusive expression excluding the presence of other components unless otherwise specified.

In addition, in the description described in the present specification, even if ordinal numbers such as "first" or "second" are used, these terms are used for convenience to facilitate understanding of the content of the embodiments, and the content of the embodiments is not limited to the order, or the like, that can be caused by these ordinal numbers.

Furthermore, in the description described in the present specification, even if terms meaning specific positions or directions such as "upper", "lower", "left", "right", "side", "bottom", "front", or "back" are used, these terms are used for convenience to facilitate understanding of the content of the embodiments, and are not related to the positions or directions when the embodiments are actually implemented.

Furthermore, in the description described in the present specification, the description of "upper surface of...", "lower surface of...", or the like, includes a state in which another component is formed on the upper surface or the lower surface of a target component in addition to the upper surface itself or the lower surface itself of the target component. In other words, for example, in a case where it is described as "B provided on the upper surface of A", it does not prevent another component "C" from being interposed between A and B.

### <First Embodiment>

Hereinafter, a substrate treatment device and a substrate treatment method according to the present embodiment will be described.

### <Configuration of substrate treatment device>

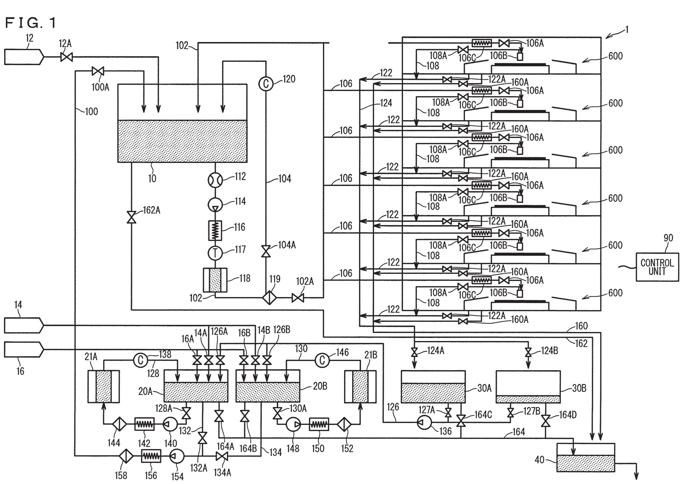

FIG. 1 is a view illustrating an example of a configuration of a substrate treatment device according to the present embodiment. As illustrated in FIG. 1, a substrate treatment device 1 includes a plurality of treatment units 600, a supply tank 10, a generation tank 20A and a generation tank 20B, an electrolytic cell 21A and an electrolytic cell 21B, a collection tank 30A and a collection tank 30B, a waste liquid tank 40 for discharging a treatment liquid, or the like, and a control unit 90.

The treatment unit 600 treats a substrate using a supplied treatment liquid. A detailed configuration of the treatment unit 600 will be described later. Note that the number of the treatment units 600 is not limited to the number illustrated in FIG. 1.

The supply tank 10 stores the treatment liquid supplied from the generation tank 20A or the generation tank 20B via a supply pipe 100. Then, the supply tank 10 supplies the treatment liquid to the treatment unit 600. Pure water (DIW), hydrogen peroxide water, or ozone water is supplied from a pure water supply source 12 to the supply tank 10. A flow rate of pure water, or the like, supplied from the pure water supply source 12 can be adjusted by the control of a valve 12A by the control unit 90. Note that the pure water supply source 12 does not have to be provided.

A pipe for supplying the treatment liquid from the supply tank 10 includes a circulation pipe 102 that is connected to the supply tank 10 and circulates the treatment liquid through the supply tank 10, a measurement pipe 104 that branches from the circulation pipe 102 and returns the treatment liquid to the supply tank 10, a supply pipe 106 that branches from the circulation pipe 102 and supplies the treatment liquid to each treatment unit 600, and a collection pipe 108 that branches at a downstream end portion of each supply pipe 106 (downstream of a heater 106C) and supplies the treatment liquid to the collection tank 30A or the collection tank 30B. Note that in FIG. 1, the collection pipe 108 is provided so as to join the waste liquid pipe 122, but may be directly connected to the collection tank 30A or the collection tank 30B.

A flow meter 112 that measures a flow rate of the treatment liquid, a pump 114 that causes the treatment liquid to flow, a heater 116 that heats the treatment liquid, a thermometer 117 that measures a temperature of the treatment liquid, and an electrolytic cell 118 that electrolyzes the treatment liquid are provided on an upstream side of a position at which the measurement pipe 104 branches, in the circulation pipe 102. Note that the electrolytic cell 118 does not have to be provided in a case where autolysis of the treatment liquid is sufficiently suppressed. In addition, the heater may be replaced with a mechanism capable of temperature adjustment including cooling, and is not limited to the case of heating. The same applies to the heaters described below.

The measurement pipe 104 is provided with a concentration meter 120 for measuring concentration of the treatment liquid flowing through the measurement pipe 104. In a case where the concentration of the treatment liquid measured by the concentration meter 120 is higher than desired concentration, pure water, or the like, is supplied from the pure water supply source 12 to the supply tank 10 under the control of the control unit 90, whereby the concentration of the treatment liquid can be reduced. In a case where the concentration of the treatment liquid measured by the concentration meter 120 is lower than the desired concentration, the treatment liquid is electrolyzed in the electrolytic cell 118 under the control of the control unit 90, and at the same time, water is electrolyzed, whereby the concentration of the treatment liquid can be increased.

On the downstream side of the position at which the measurement pipe 104 branches, in the circulation pipe 102, a filter 119 that removes particles, and the like, in the treatment liquid and a valve 102A capable of adjusting the flow rate of the treatment liquid circulating in the circulation pipe 102 under the control of the control unit 90 are provided.

The supply pipe 106 is provided with the heater 106C that heats a supplied liquid (including a treatment liquid not used for substrate treatment) which is a treatment liquid having been supplied from the circulation pipe 102 to the supply pipe 106, and a valve 106A that can adjust a flow rate of the supplied liquid flowing through the supply pipe 106 under the control of the control unit 90. The supplied liquid having a partial flow rate of the treatment liquid flowing through the circulation pipe 102 flows through the supply pipe 106. Note that while the heater 106C illustrated in FIG. 1 is provided in the treatment unit 600, the heater 106C may be accommodated in a fluid box, or the like, outside the treatment unit 600.

The collection pipe 108 is provided with a valve 108A capable of adjusting the flow rate of the supplied liquid flowing through the collection pipe 108 under the control of the control unit 90.

Further, a portion where the collection pipe 108 branches from the supply pipe 106 is provided in a discharge nozzle 106B of the treatment unit 600.

A pipe for collecting the treatment liquid from the treatment unit 600 includes a waste liquid pipe 122 connected to each treatment unit 600 and discharging a supplied liquid (treated liquid) used for substrate treatment, a collection pipe 124 that supplies the treated liquid joined from each waste liquid pipe 122 to the collection tank 30A or the collection tank 30B, a collection pipe 126 connected to the collection tank 30A and the collection tank 30B and supplying the treated liquid to the generation tank 20A or the generation tank 20B, a circulation pipe 128 that circulates the treatment liquid between the generation tank 20A and the electrolytic cell 21A, a circulation pipe 130 that circulates the treatment liquid between the generation tank 20B and the electrolytic cell 21B, and a supply pipe 132 that joins the treatment liquid from the generation tank 20A to the supply pipe 100, a supply pipe 134 that joins the treatment liquid from the generation tank 20B to the supply pipe 100. The waste liquid pipe 122 is provided with a valve 122A that adjusts a flow rate of the waste liquid from the treatment unit 600 under the control of the control unit 90. The collection pipe 124 is provided with a valve 124A that adjusts a flow rate of the waste liquid (treated liquid) to the collection tank 30A under the control of the control unit 90 and a valve 124B that adjusts a flow rate of the waste liquid (treated liquid) to the collection tank 30B under the control of the control unit 90.

The treated liquid from the collection pipe 124 is selectively supplied to the plurality of collection tanks, so that it is possible to lengthen a period until the treated liquid is supplied from the collection tank to the generation tank. Here, only one collection tank may be provided.

The collection pipe 126 is provided with a pump 136 for feeding the treated liquid stored in the collection tank 30A or the collection tank 30B to the generation tank 20A or the generation tank 20B, a valve 127A capable of adjusting a flow rate of the treated liquid to be fed from the collection tank 30A under the control of the control unit 90, a valve 127B capable of adjusting a flow rate of the treated liquid to be fed from the collection tank 30B under the control of the control unit 90, a valve 126A capable of adjusting a flow rate of the treated liquid to be fed to the generation tank 20A under the control of the control unit 90, and a valve 126B capable of adjusting a flow rate of the treated liquid to be fed to the generation tank 20B under the control of the control unit 90.

The circulation pipe 128 is provided with a valve 128A for adjusting a flow rate of the treatment liquid flowing through the circulation pipe 128, a concentration meter 138 for measuring concentration of the treatment liquid flowing through the circulation pipe 128, a pump 140 for feeding the treatment liquid flowing through the circulation pipe 128, a heater 142 that heats the treatment liquid, and a filter 144 that removes particles, and the like, in the treatment liquid.

The circulation pipe 130 is provided with a valve 130A for adjusting a flow rate of the treatment liquid flowing through the circulation pipe 130, a concentration meter 146 for measuring concentration of the treatment liquid flowing through the circulation pipe 130, a pump 148 for feeding the treatment liquid flowing through the circulation pipe 130, a heater 150 that heats the treatment liquid, and a filter 152 that removes particles, and the like, in the treatment liquid.

The supply pipe 132 is provided with a valve 132A capable of adjusting a flow rate of the treatment liquid flowing through the supply pipe 132 under the control of the control unit 90.

The supply pipe 134 is provided with a valve 134A capable of adjusting a flow rate of the treatment liquid flowing through the supply pipe 134 under the control of the control unit 90.

The supply pipe 100 is provided with a pump 154 for feeding the treatment liquid flowing through the supply pipe 100, a heater 156 that heats the treatment liquid, a filter 158 that removes particles, and the like, in the treatment liquid, and a valve 100A for adjusting a flow rate of the treatment liquid flowing through the supply pipe 100.

Further, pure water (DIW), hydrogen peroxide water, or ozone water is supplied from a pure water supply source 14 to the generation tank 20A and the generation tank 20B. A flow rate of pure water, or the like, to be supplied from the pure water supply source 14 to the generation tank 20A can be adjusted by the control of the valve 14A by the control unit 90. A flow rate of pure water, or the like, to be supplied from the pure water supply source 14 to the generation tank 20B can be adjusted by the control of the valve 14B by the control unit 90. Note that the pure water supply source 14 does not have to be provided.

Sulfuric acid (H₂SO₄) is supplied from a sulfuric acid supply source 16 to the generation tank 20A and the generation tank 20B. A flow rate of the sulfuric acid to be supplied from the sulfuric acid supply source 16 to the generation tank 20A can be adjusted by the control of the valve 16A by the control unit 90. A flow rate of the sulfuric acid to be supplied from the sulfuric acid supply source 16 to the generation tank 20B can be adjusted by the control of the valve 16B by the control unit 90. Note that the sulfuric acid supply source 16 does not have to be provided.

A pipe for discharging the treatment liquid and the treated liquid includes a waste liquid pipe 160 for discharging the treated liquid from each treatment unit 600 to the waste liquid tank 40, a waste liquid pipe 162 for discharging the treatment liquid from the supply tank 10 to the waste liquid tank 40, and a waste liquid pipe 164 for discharging the treatment liquid or the treated liquid from the generation tank 20A, the generation tank 20B, the collection tank 30A, and the collection tank 30B to the waste liquid tank 40. The waste liquid pipe 160 is provided with a valve 160A that adjusts a flow rate of the waste liquid from the treatment unit 600 under the control of the control unit 90. The waste liquid pipe 162 is provided with a valve 162A that adjusts a flow rate of the waste liquid from the supply tank 10 under the control of the control unit 90. The waste liquid pipe 164 is provided with a valve 164A that adjusts a flow rate of the waste liquid from the generation tank 20A under the control of the control unit 90, a valve 164B that adjusts a flow rate of the waste liquid from the generation tank 20B under the control of the control unit 90, a valve 164C that adjusts a flow rate of the waste liquid from the collection tank 30A under the control of the control unit 90, and a valve 164D that adjusts a flow rate of the waste liquid from the collection tank 30B under the control of the control unit 90.

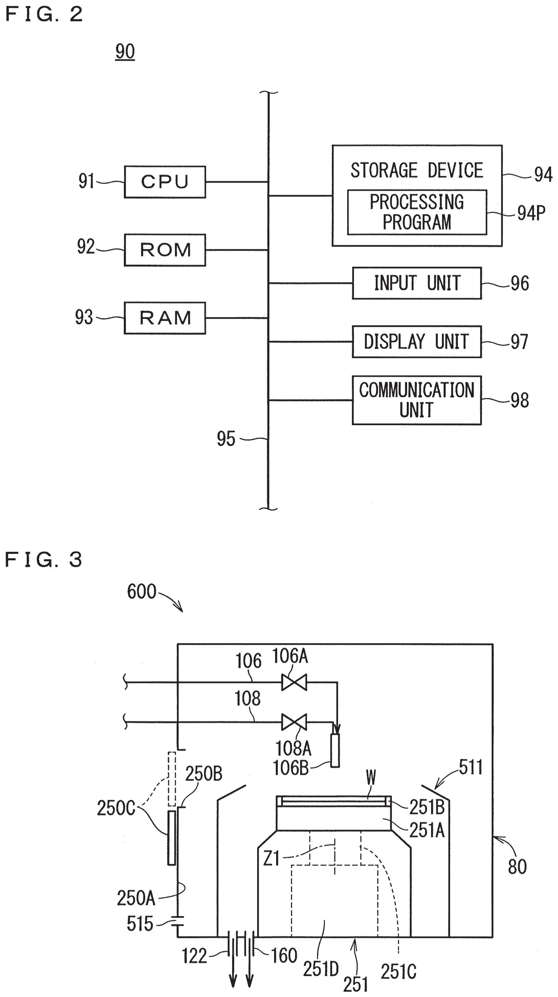

FIG. 2 is a view conceptually illustrating an example of a configuration of the control unit 90 for which an example is illustrated in FIG. 1. The control unit 90 may include a general computer having an electric circuit. Specifically, the control unit 90 includes a central processing unit (CPU) 91, a read only memory (ROM) 92, a random access memory (RAM) 93, a storage device 94, an input unit 96, a display unit 97, a communication unit 98, and a bus line 95 connecting these units to each other.

The ROM 92 stores a basic program. The RAM 93 is used as a work area when the CPU 91 performs predetermined processing. The storage device 94 includes a non-volatile storage device such as a flash memory or a hard disk device. The input unit 96 includes various switches, a touch panel, or the like, and receives an input setting instruction such as a treatment recipe from an operator. The display unit 97 includes, for example, a liquid crystal display device, a lamp, and the like, and displays various types of information under the control of the CPU 91. The communication unit 98 has a data communication function via a local area network (LAN), or the like.

In the storage device 94, a plurality of modes for controlling each component in the substrate treatment device 1 of FIG. 1 is set in advance. By the CPU 91 executing a processing program 94P, one of the plurality of modes is selected, and each component is controlled in the mode. Note that the processing program 94P may be stored in a recording medium. By using this recording medium, the processing program 94P can be installed in the control unit 90. In addition, some or all of the functions to be executed by the control unit 90 are not necessarily implemented by software, and may be implemented by hardware such as a dedicated logic circuit.

FIG. 3 is a view schematically illustrating an example of the treatment unit 600 and related components in the substrate treatment device according to the present embodiment. Note that while FIG. 3 illustrates an example of the configuration of the treatment unit 600 arranged downstream of one supply pipe 106 in FIG. 1, the configuration of the treatment unit 600 arranged downstream of the other supply pipes 106 is also similar to the case illustrated in FIG. 3.

As illustrated in FIG. 3 as an example, the treatment unit 600 includes a box-shaped chamber 80 having an internal space, a spin chuck 251 that rotates a substrate W around a vertical rotation axis Z1 passing through a central portion of the substrate W while holding one substrate W in a horizontal posture in the chamber 80, and a tubular treatment cup 511 surrounding the spin chuck 251 around the rotation axis Z1 of the substrate W.

The chamber 80 is surrounded by a box-shaped wall 250A. An opening 250B for carrying the substrate W into and out of the chamber 80 is formed in the wall 250A.

The opening 250B is opened and closed by a shutter 250C. The shutter 250C is lifted or lowered between a closed position (indicated by a two-dot chain line in FIG. 3) at which the opening 250B is covered and an open position (indicated by a solid line in FIG. 3) at which the opening 250B is opened by a shutter lifting and lowering mechanism (not illustrated here).

As illustrated in FIG. 3, the spin chuck 251 includes a disk-shaped spin base 251A provided to face the substrate W in a horizontal posture, a plurality of chuck pins 251B protruding upward from an outer peripheral portion of an upper surface of the spin base 251A and clamping a peripheral portion of the substrate W, a rotation shaft 251C extending downward from a central portion of the spin base 251A, and a spin motor 251D rotating the rotation shaft 251C to rotate the substrate W attracted to the spin base 251A.

Note that the spin chuck 251 is not limited to a clamping type chuck illustrated in the example in FIG. 3, and may be, for example, a vacuum suction type chuck including a spin base that vacuum-sucks the lower surface of the substrate W.

A nozzle (for example, a nozzle that discharges another chemical liquid, a nozzle that discharges a rinse liquid, or the like) for discharging a liquid for another use may be connected to the treatment unit 600.

Further, as illustrated in the example in FIG. 3, a discharge nozzle 106B that discharges the treatment liquid is connected to a distal end of the supply pipe 106 connected to the treatment unit 600. The discharge nozzle 106B discharges the treatment liquid toward a predetermined portion (for example, the spin base 251A) inside the chamber 80.

The treatment cup 511 is provided so as to surround the periphery of the spin chuck 251, and is lifted and lowered in the vertical direction by a lifting and lowering mechanism (motor, cylinder, or the like) (not illustrated). An upper portion of the treatment cup 511 is lifted and lowered between an upper position where the upper end thereof is above the substrate W held by the spin base 251A and a lower position where the upper end thereof is below the substrate W.

The treatment liquid scattered outward from the upper surface of the substrate W is received by an inner surface of the treatment cup 511. Then, the treatment liquid received by the treatment cup 511 is appropriately discharged to the outside of the chamber 80 via the waste liquid pipe 122 and the waste liquid pipe 160 provided at the bottom of the chamber 80 and inside the treatment cup 511. In addition, an atmosphere in the treatment cup 511 is exhausted by a cup exhaust mechanism (not illustrated).

Further, an exhaust port 515 is provided in a side portion of the chamber 80. An atmosphere in the chamber 80 is appropriately discharged to the outside of the chamber 80 through the exhaust port 515.

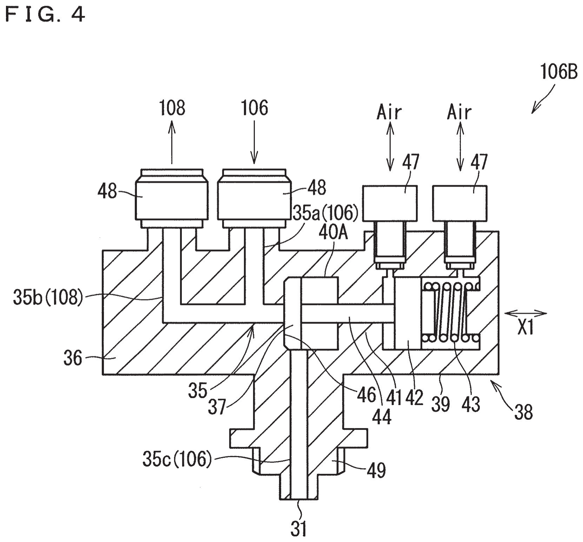

FIG. 4 is a cross-sectional view illustrating an example of an internal structure of the discharge nozzle 106B.

The discharge nozzle 106B includes a main body 36 in which a flow path 35 that guides the treatment liquid is formed, a valve body 37 that opens and closes the flow path 35, a pneumatic actuator 38 that moves the valve body 37 forward and backward in an axial direction X1 to open and close the flow path 35, and a discharge port 31.

The main body 36 includes a cylinder 39 constituting the pneumatic actuator 38, a valve chamber 40A that moves the valve body 37 forward and backward, a flow path 35a that communicates with the supply pipe 106 via a joint 48 and reaches the valve chamber 40A, a flow path 35b that is connected to the flow path 35a at a position upstream of the valve chamber 40A in the flow path 35a and communicates with the collection pipe 108 via the joint 48, and a flow path 35c that reaches the discharge port 31 from the valve chamber 40A.

The cylinder 39 and the valve chamber 40A are arranged in the axial direction X1. The cylinder 39 and the valve chamber 40A are separated from each other by a partition wall 41. The flow path 35a and the flow path 35c correspond to part of the supply pipe 106 that guides the treatment liquid supplied from the supply tank 10 toward the discharge port 31. The flow path 35b corresponds to part of the collection pipe 108 that supplies the treatment liquid to the collection tank 30A or the collection tank 30B.

The pneumatic actuator 38 includes a cylinder 39, a piston 42, a spring 43, and a rod 44. The cylinder 39 is separated by the piston 42 into a front chamber on the partition wall 41 side and a rear chamber on the opposite side in the axial direction X1 across the piston 42. A joint 47 is connected to the main body 36 for connecting a tube that transmits air pressure separately to the front chamber and the rear chamber of the cylinder 39. The piston 42 is moved forward and backward in the cylinder 39 along the axial direction X1 by transmitting air pressure to either the front chamber or the rear chamber of the cylinder 39 via the tube and the joint 47.

The spring 43 is interposed between the piston 42 and the main body 36 on the rear chamber side of the cylinder 39 to press the piston 42 toward the partition wall 41.

A base portion of the rod 44 is connected to the piston 42, and a distal end portion thereof penetrates the partition wall 41 and protrudes to the valve chamber 40A. A valve body 37 is connected to a distal end portion of the rod 44 protruding to the valve chamber 40A. The valve body 37 is formed in a disk shape, and is connected to a distal end portion of the rod 44 so that a radial direction is orthogonal to the axial direction X1. When the piston 42 is moved forward and backward in the cylinder 39 along the axial direction X1, the valve body 37 is moved forward and backward in the axial direction X1 in the valve chamber 40A via the rod 44.

The valve chamber 40A includes an annular valve seat surface 46 facing the partition wall 41 and orthogonal to the axial direction X1, and a flow path 35a is concentrically opened at the center position of the valve seat surface 46. The flow path 35c is opened to the side of the valve chamber 40A in the forward and backward direction (axial direction X1) of the valve body 37.

The main body 36 has a discharge port 31 formed at a distal end, and includes a cylindrical portion 49 protruding downward from the lower surface of the nozzle head 26.

In a state where no air pressure is applied to either the front chamber or the rear chamber of the cylinder 39 and the pneumatic actuator 38 is not operated, the piston 42 is pressed by the spring 43 to a forward position in the cylinder 39, that is, a position close to the partition wall 41 side as illustrated in the example in FIG. 4, so that the valve body 37 is brought into contact with the valve seat surface 46 in the valve chamber 40A, and the opening of the flow path 35a is closed.

Thus, a space between the flow path 35a and the flow path 35c is closed, and the treatment liquid supplied from the supply tank 10 through the supply pipe 106 and the flow path 35a is collected in the collection tank 30A or the collection tank 30B through the flow path 35b and the collection pipe 108 (collection state).

In this collection state, if the air pressure is transmitted to the front chamber of the cylinder 39 to move the piston 42 backward in the rear chamber direction of the cylinder 39 against the pressing force of the spring 43, the valve body 37 is separated from the valve seat surface 46 in the valve chamber 40A, and the opening of the flow path 35a is released to the valve chamber 40A. Thus, the flow path 35a and the flow path 35c are connected via the valve chamber 40A, and the treatment liquid supplied from the supply tank 10 through the supply pipe 106 and the flow path 35a is discharged from the discharge port 31 through the flow path 35c (discharge state).

In this discharge state, when transmission of the air pressure to the front chamber of the cylinder 39 is stopped, and instead, the air pressure is transmitted to the rear chamber of the cylinder 39 to move the piston 42 forward in the front chamber direction of the cylinder 39, that is, in the direction approaching the partition wall 41 together with the pressing force of the spring 43, the valve body 37 is brought into contact with the valve seat surface 46 in the valve chamber 40A, and the opening of the flow path 35a is closed. Thus, the space between the flow path 35a and the flow path 35c is closed, and the treatment liquid supplied from the supply tank 10 through the supply pipe 106 and the flow path 35a returns to the collection state in which the treatment liquid is collected in the collection tank 30A or the collection tank 30B through the flow path 35b and the collection pipe 108.

### <Operation of substrate treatment device>

Next, operation of the substrate treatment device will be described. A substrate treatment method by the substrate treatment device according to the present embodiment includes a step of discharging the treatment liquid onto the substrate W conveyed to the treatment unit 600 to perform substrate treatment, a step of cleaning the substrate W subjected to the substrate treatment, a step of rotating and drying the cleaned substrate W, and a step of carrying the dried substrate W out of the treatment unit 600.

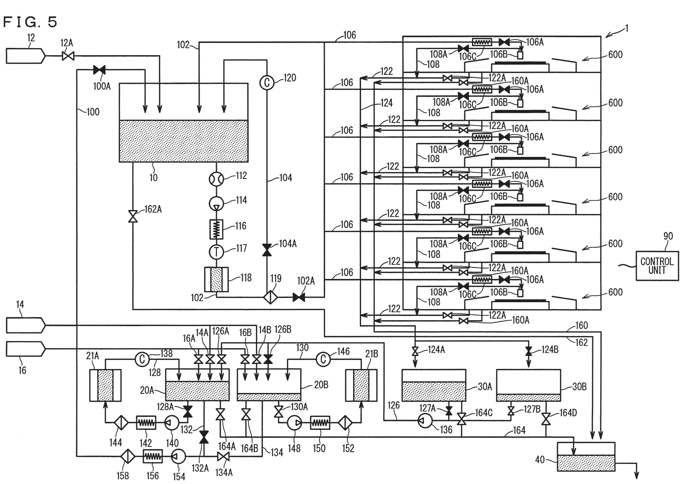

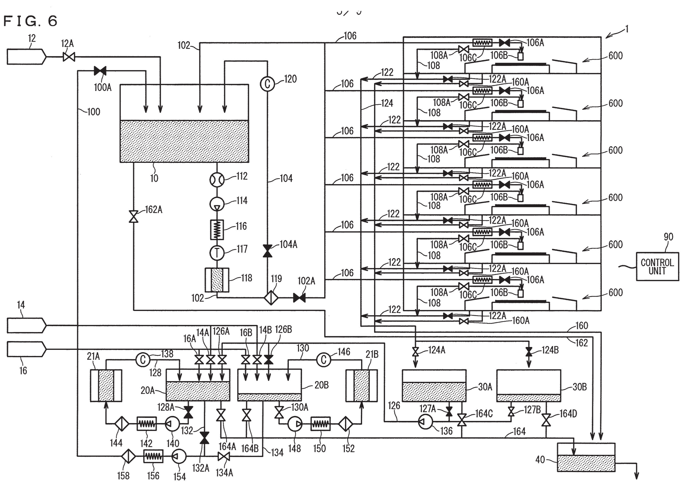

Hereinafter, substrate treatment included in the operation of the substrate treatment device will be described with reference to FIGS. 5 and 6. Here, FIG. 5 is a view illustrating an example of a configuration of the substrate treatment device in a collection state of the discharge nozzle 106B. Further, FIG. 6 is a view illustrating an example of a configuration of the substrate treatment device in a discharge state of the discharge nozzle 106B. In FIGS. 5 and 6, the valve in the open state is illustrated in black. Note that the operation described below is performed by the control unit 90 controlling the operation of each component (such as a pump, a heater, a valve or a spin motor) in the substrate treatment device 1.

First, sulfuric acid (H₂SO₄) is circulated between the generation tank 20A and the electrolytic cell 21A through the circulation pipe 128 to generate a treatment liquid containing electrolytic sulfuric acid. Here, the electrolytic sulfuric acid refers to a persulfuric acid (peroxodisulfuric acid, that is, H₂S₂O₈). Persulfuric acid has stronger oxidizing power than caloric acid (H₂SO₅) at the same temperature.

Sulfuric acid is appropriately supplied from the sulfuric acid supply source 16 to the generation tank 20A by the control of the valve 16A by the control unit 90. Pure water (DIW), or the like, is appropriately supplied from the pure water supply source 14 by the control of the valve 14A by the control unit 90. Further, as will be described later, the treated liquid is supplied to the generation tank 20A from the collection tank 30A or the collection tank 30B by the control of the valve 126A by the control unit 90.

A temperature of the treatment liquid stored in the generation tank 20A is adjusted to, for example, equal to or lower than 60°C by the heater 142 in the circulation pipe 128 in a state where the valve 128A is opened, particles, and the like, are appropriately removed by the filter 144, and the treatment liquid is fed to the electrolytic cell 21A by the pump 140. By adjusting the temperature of the treatment liquid to equal to or lower than 60°C (electrolysis temperature), a generation rate of electrolytic sulfuric acid increases in a case where sulfuric acid is electrolyzed. In addition, by adjusting the temperature of the treatment liquid to equal to or lower than 60°C, the electrolytic sulfuric acid is suppressed from being autolyzed into caloric acid (H₂SO₅) and OH radicals.

Then, in the electrolytic cell 21A, sulfuric acid whose temperature has been adjusted is electrolyzed to generate a treatment liquid containing electrolytic sulfuric acid and sulfuric acid. Here, when sulfuric acid is electrolyzed, water molecules in the treatment liquid are also electrolyzed, and thus, the concentration of the treatment liquid increases as the sulfuric acid is electrolyzed. The concentration of the treatment liquid containing electrolytic sulfuric acid is measured by the concentration meter 138, and the control unit 90 controls a flow rate of the treatment liquid to be fed to the electrolytic cell 21A based on the measured concentration (that is, by the control of opening and closing of the valve 128A, the flow rate of the treatment liquid is increased in a case where the measured concentration is low, and the flow rate of the treatment liquid is decreased in a case where the measured concentration is high). Note that if the concentration of electrolytic sulfuric acid is decreased, generation efficiency of persulfuric acid increases.

The generation tank 20A has a redundant configuration with the generation tank 20B. Thus, as in the case of the generation tank 20A, sulfuric acid (H₂SO₄) is circulated between the generation tank 20B and the electrolytic cell 21B via the circulation pipe 130 to generate a treatment liquid containing electrolytic sulfuric acid.

To the generation tank 20B, sulfuric acid is appropriately supplied from the sulfuric acid supply source 16 by the control of the valve 16B by the control unit 90. Pure water (DIW), or the like, is appropriately supplied from the pure water supply source 14 by the control of the valve 14B by the control unit 90. Further, as will be described later, the treated liquid is supplied to the generation tank 20B from the collection tank 30A or the collection tank 30B by the control of the valve 126B by the control unit 90.

A temperature of the treatment liquid stored in the generation tank 20B is adjusted to an electrolysis temperature (for example, equal to or lower than 60°C) by the heater 150 in the circulation pipe 130 in a state where the valve 130A is opened, particles, and the like, are appropriately removed by the filter 152, and the treatment liquid is fed to the electrolytic cell 21B by the pump 148.

Then, sulfuric acid whose temperature has been adjusted in the electrolytic cell 21B is electrolyzed to generate a treatment liquid containing electrolytic sulfuric acid and sulfuric acid. The concentration of the treatment liquid containing electrolytic sulfuric acid is measured by the concentration meter 146, and the control unit 90 adjusts the flow rate of the treatment liquid to be fed to the electrolytic cell 21B by the control of opening and closing of the valve 130A based on the measured concentration.

The generation tank 20A and the generation tank 20B can supply the treatment liquid to the supply tank 10 in a switchable manner. For example, as illustrated in the example in FIG. 5, while the valve 128A is opened to circulate the treatment liquid in the circulation pipe 128, the valve 132A is opened to supply the treatment liquid from the generation tank 20A to the supply tank 10, and during this time, the treated liquid from the collection tank 30A or the collection tank 30B can be stored in the generation tank 20B by closing the valve 130A and the valve 134A. Alternatively, in a case where the concentration of the electrolytic sulfuric acid stored in the generation tank 20A does not reach the desired concentration, by closing the valve 132A while opening the valve 128A to continue circulation of the treatment liquid in the circulation pipe 128 to increase the concentration of the treatment liquid by electrolysis of sulfuric acid and opening the valve 130A and the valve 134A, the treatment liquid reaching the desired concentration circulated in the circulation pipe 130 can be supplied from the generation tank 20B to the supply tank 10. In other words, even while the treatment liquid is being generated in one generation tank (electrolytic cell), the treatment liquid can be continuously supplied from the other generation tank.

The temperature of the treatment liquid supplied from any (or both) generation tank is adjusted to, for example, equal to or lower than 60°C by the heater 156 in the supply pipe 100, particles, and the like, are appropriately removed by the filter 158, and the treatment liquid is fed to the supply tank 10 by the pump 154 via the valve 100A in the open state.

The collection tank 30A and the collection tank 30B can supply the supplied liquid to the generation tank 20A or the generation tank 20B in a switchable manner. For example, as illustrated in the example in FIG. 5, while the valve 124A is closed to stop the supplied liquid supplied to the collection tank 30A, the valve 127A is opened to supply the supplied liquid from the collection tank 30A to the generation tank 20A or the generation tank 20B, and during this time, the supplied liquid can be stored in the collection tank 30B by opening the valve 124B and closing the valve 127B.

The supply tank 10 stores the treatment liquid supplied from the generation tank via the supply pipe 100. Further, pure water (DIW), or the like, is appropriately supplied from the pure water supply source 12 to the supply tank 10, so that the concentration of the treatment liquid is adjusted.

The temperature of the treatment liquid to be fed from the supply tank 10 through the circulation pipe 102 is adjusted by the heater 116 so that the temperature measured by the thermometer 117 in the circulation pipe 102 becomes, for example, equal to or lower than 60°C, particles, and the like, are appropriately removed by the filter 119, and the treatment liquid is fed again to the supply tank 10 by the pump 114. The control unit 90 grasps the substrate treatment to be performed by the treatment unit 600 with reference to the treatment recipe, and adjusts the flow rate of the treatment liquid circulating in the circulation pipe 102 by opening and closing the valve 102A, or the like, so that the flow rate of the treatment liquid measured by the flow meter 112 becomes a flow rate sufficient for the substrate treatment.

Here, the heater 116 may increase the temperature of the treatment liquid to a temperature (referred to as a circulation temperature) higher than an electrolysis temperature (equal to or lower than 60°C), which is a temperature suitable for generating electrolytic sulfuric acid. This makes it possible to reduce a temperature range when the temperature of the treatment liquid is increased to the temperature for substrate treatment (treatment temperature) by the heater 106C on the further downstream side, making it unnecessary for the heater 106C to have high temperature increasing performance. This improves a degree of freedom in setting of the heater 106C. Note that the circulation temperature is, for example, 80°C at which a rate of autolysis of electrolytic sulfuric acid is assumed to be sufficiently low.

The measurement pipe 104 branching from the circulation pipe 102 is provided with a valve 104A that adjusts the flow rate under the control of the control unit 90 and the concentration meter 120. The control unit 90 performs control such as opening the valve 12A to supply pure water, or the like, from the pure water supply source 12 to the supply tank 10, or electrolysis of the treatment liquid in the electrolytic cell 118 to increase the concentration of the treatment liquid with reference to the concentration of the treatment liquid measured by the concentration meter 120.

On the downstream side of the circulation pipe 102, a supply pipe 106 branching into each treatment unit 600 is provided. Then, by opening the corresponding valve 106A under the control of the control unit 90, it is possible to appropriately supply the treatment liquid to the treatment unit 600 while circulating the treatment liquid in the circulation pipe 102.

In the collection state of the discharge nozzle 106B (state in which the valve body 37 of FIG. 4 is in contact with the valve seat surface 46), the valve 106A and the valve 108A are opened, and the treatment liquid supplied from the circulation pipe 102 to the supply pipe 106 and further to the collection pipe 108 joins the waste liquid pipe 122 and is collected in the collection tank 30A or the collection tank 30B. As described above, the treatment liquid flows into the discharge nozzle 106B in the supply pipe 106 and is collected, so that it is possible to suppress a temperature change of the treatment liquid due to a temperature difference between the pipe and the treatment liquid when the treatment liquid is discharged to perform the substrate treatment. It is desirable that the treatment liquid supplied through the collection pipe 108 in the collection state be suppressed to a minimum flow rate for maintaining the temperature of the pipe.

In the discharge state of the discharge nozzle 106B (state in which the valve body 37 in FIG. 4 is separated from the valve seat surface 46), the valve 106A is opened while the valve 108A is closed, and the treatment liquid is discharged from the discharge port 31 of the discharge nozzle 106B toward the upper surface of the substrate W. Then, substrate treatment is performed.

The treatment liquid discharged to the substrate W and used for the substrate treatment flows as a treated liquid into the waste liquid pipe 122 through the valve 122A in the open state. The treated liquid contains sulfate ions (SO₄²⁻). Then, the treated liquid joins the collection pipe 124 and is collected in the collection tank 30A or the collection tank 30B.

The electrolytic sulfuric acid can be used again for substrate treatment by being collected and electrolyzed again. Thus, by performing the substrate treatment using the treatment liquid containing the electrolytic sulfuric acid, the waste liquid in association with the substrate treatment can be reduced.

The treated liquid stored in the collection tank 30A or the collection tank 30B can be selectively (that is, to one or both) fed to the generation tank 20A by opening the valve 126A and to the generation tank 20B by opening the valve 126B via the collection pipe 126 by the pump 136.

### <Second Embodiment>

A substrate treatment device and a substrate treatment method according to the present embodiment will be described. Note that, in the following description, components similar to the components described in the embodiment described above are denoted by the same reference numerals, and detailed description thereof will be omitted as appropriate.

### <Configuration of substrate treatment device>

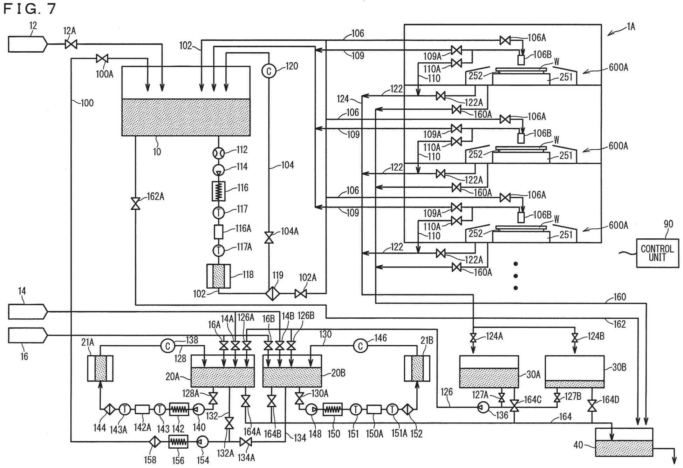

FIG. 7 is a view illustrating an example of a configuration of a substrate treatment device according to the present embodiment. As illustrated in FIG. 7 as an example, a substrate treatment device 1A includes a plurality of treatment units 600A, the supply tank 10, the generation tank 20A and the generation tank 20B, the electrolytic cell 21A and the electrolytic cell 21B, the collection tank 30A and the collection tank 30B, the waste liquid tank 40 that discharges a treatment liquid, or the like, and the control unit 90.

The treatment unit 600A treats a substrate using the supplied treatment liquid. The supply tank 10 stores the treatment liquid supplied from the generation tank 20A or the generation tank 20B via the supply pipe 100. Then, the supply tank 10 supplies the treatment liquid to the treatment unit 600A.

A pipe for supplying the treatment liquid from the supply tank 10 includes the circulation pipe 102, the measurement pipe 104, the supply pipe 106, the circulation pipe 109 that branches at the downstream end portion of each supply pipe 106 and returns the treatment liquid to the supply tank 10 side, and the collection pipe 110 that branches from the circulation pipe 109 and supplies the treatment liquid to the collection tank 30A or the collection tank 30B. Note that the collection pipe 110 does not have to be provided.

The flow meter 112, the pump 114, the heater 116, the thermometer 117, a heat exchanger 116A that cools the treatment liquid, a thermometer 117A that measures the temperature of the treatment liquid, and an electrolytic cell 118 are provided on the upstream side of a position at which the measurement pipe 104 branches, in the circulation pipe 102.

The concentration meter 120 is provided in the measurement pipe 104. In a case where the concentration of the treatment liquid measured by the concentration meter 120 is higher than desired concentration, pure water, or the like, is supplied from the pure water supply source 12 to the supply tank 10 under the control of the control unit 90, whereby the concentration of the treatment liquid can be reduced. In a case where the concentration of the treatment liquid measured by the concentration meter 120 is lower than the desired concentration, the treatment liquid is electrolyzed in the electrolytic cell 118 under the control of the control unit 90, and at the same time, water is electrolyzed, whereby the concentration of the treatment liquid can be increased.

The filter 119 and the valve 102A are provided on the downstream side of a position at which the measurement pipe 104 branches, in the circulation pipe 102.

The supply pipe 106 is provided with the valve 106A capable of adjusting the flow rate of the supplied liquid flowing through the supply pipe 106 under the control of the control unit 90. The supplied liquid having a partial flow rate of the treatment liquid flowing through the circulation pipe 102 flows through the supply pipe 106.

The treatment unit 600A includes the chamber 80, the spin chuck 251, the heater 252 provided on a surface of the spin chuck 251 facing the substrate W, and the treatment cup 511. The heater 252 can indirectly heat the treatment liquid on the upper surface of the substrate W by heating the substrate W to a predetermined temperature under the control of the control unit 90.

The circulation pipe 109 is provided with the valve 109A capable of adjusting the flow rate of the supplied liquid flowing through the circulation pipe 109 under the control of the control unit 90. The valve 109A is provided downstream of a portion at which the collection pipe 110 branches. Further, a portion at which the circulation pipe 109 branches from the supply pipe 106 is provided in the discharge nozzle 106B in the treatment unit 600A.

The collection pipe 110 is provided with the valve 110A capable of adjusting the flow rate of the supplied liquid flowing through the collection pipe 110 under the control of the control unit 90.

A pipe for collecting the treatment liquid from the treatment unit 600A includes the waste liquid pipe 122, the collection pipe 124, the collection pipe 126, the circulation pipe 128, the circulation pipe 130, the supply pipe 132, and the supply pipe 134. The waste liquid pipe 122 is provided with the valve 122A. The collection pipe 124 is provided with the valve 124A and the valve 124B.

The collection pipe 126 is provided with the pump 136, the valve 127A, the valve 127B, the valve 126A, and the valve 126B.

The circulation pipe 128 is provided with the valve 128A, the pump 140, the heater 142, the thermometer 143 that measures the temperature of the treatment liquid, the heat exchanger 142A that cools the treatment liquid, the thermometer 143A that measures the temperature of the treatment liquid, the filter 144, and the concentration meter 138.

The circulation pipe 130 is provided with the valve 130A, the pump 148, the heater 150, a thermometer 151 that measures the temperature of the treatment liquid, a heat exchanger 150A that cools the treatment liquid, a thermometer 151A that measures the temperature of the treatment liquid, a filter 152, and a concentration meter 146.

The supply pipe 132 is provided with the valve 132A. The supply pipe 134 is provided with the valve 134A.

The supply pipe 100 is provided with a pump 154, a heater 156, a filter 158, and a valve 100A.

Further, pure water (DIW), hydrogen peroxide water, or ozone water is supplied from the pure water supply source 14 to the generation tank 20A and the generation tank 20B.

Sulfuric acid (H₂SO₄) is supplied from the sulfuric acid supply source 16 to the generation tank 20A and the generation tank 20B.

A pipe for discharging the treatment liquid and the treated liquid includes a waste liquid pipe 160, a waste liquid pipe 162, and a waste liquid pipe 164. The waste liquid pipe 160 is provided with a valve 160A. The waste liquid pipe 162 is provided with a valve 162A. The waste liquid pipe 164 is provided with a valve 164A, a valve 164B, a valve 164C, and a valve 164D.

### <Operation of substrate treatment device>

Next, operation of the substrate treatment device will be described. A substrate treatment method by the substrate treatment device according to the present embodiment includes a step of discharging a treatment liquid onto the substrate W conveyed to the treatment unit 600A to perform substrate treatment, a step of cleaning the substrate W subjected to the substrate treatment, a step of rotating and drying the cleaned substrate W, and a step of carrying the dried substrate W out of the treatment unit 600A.

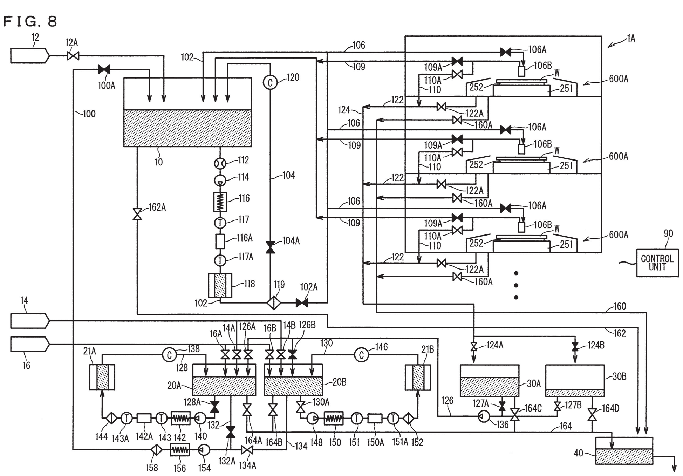

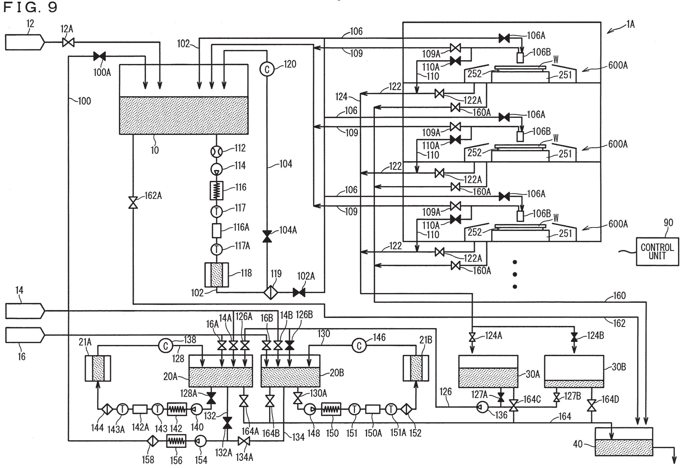

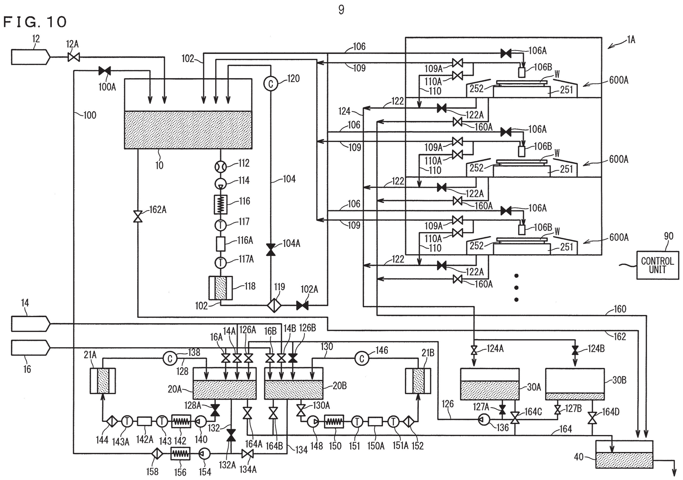

Hereinafter, the substrate treatment included in the operation of the substrate treatment device will be described with reference to FIGS. 8, 9, and 10. Here, FIG. 8 is a view illustrating an example of a configuration of the substrate treatment device in a circulation state of the discharge nozzle 106B. Further, FIG. 9 is a view illustrating an example of the configuration of the substrate treatment device in a collection state of the discharge nozzle 106B. Still further, FIG. 10 is a view illustrating an example of the configuration of the substrate treatment device in a discharge state of the discharge nozzle 106B. In FIGS. 8, 9, and 10, the valve in an open state is indicated in black. Note that the operation described below is performed by the control unit 90 controlling the operation of each component (such as a pump, a heater, a valve or a spin motor) in the substrate treatment device 1A.

First, sulfuric acid (H₂SO₄) is circulated between the generation tank 20A and the electrolytic cell 21A through the circulation pipe 128 to generate a treatment liquid containing electrolytic sulfuric acid.

Sulfuric acid is appropriately supplied from the sulfuric acid supply source 16 to the generation tank 20A by the control of the valve 16A by the control unit 90. Pure water (DIW), or the like, is appropriately supplied from the pure water supply source 14 by the control of the valve 14A by the control unit 90. The treated liquid is supplied to the generation tank 20A from the collection tank 30A or the collection tank 30B by the control of the valve 126A by the control unit 90.

The temperature of the treatment liquid stored in the generation tank 20A is adjusted to, for example, equal to or lower than 60°C by the heater 142 and the heat exchanger 142A in the circulation pipe 128 in a state where the valve 128A is opened, particles, and the like, are appropriately removed by the filter 144, and the treatment liquid is fed to the electrolytic cell 21A by the pump 140. Heat may be generated during the electrolytic treatment (electrolysis) in the electrolytic cell 21A, and thus, the heat exchanger 142A is preferably provided in order to adjust the temperature of the treatment liquid to equal to or lower than 60°C. By adjusting the temperature of the treatment liquid to equal to or lower than 60°C (electrolysis temperature), a generation rate of electrolytic sulfuric acid increases in a case where sulfuric acid is electrolyzed. In addition, by adjusting the temperature of the treatment liquid to equal to or lower than 60°C, the electrolytic sulfuric acid is suppressed from being autolyzed into caloric acid (H₂SO₅) and OH radicals.

Then, in the electrolytic cell 21A, sulfuric acid whose temperature has been adjusted is electrolyzed to generate a treatment liquid containing electrolytic sulfuric acid and sulfuric acid. Here, when sulfuric acid is electrolyzed, water molecules in the treatment liquid are also electrolyzed, and thus, the concentration of the treatment liquid increases as the sulfuric acid is electrolyzed. The concentration of the treatment liquid containing electrolytic sulfuric acid is measured by the concentration meter 138, and the control unit 90 controls the flow rate of the treatment liquid to be fed to the electrolytic cell 21A based on the measured concentration.

The generation tank 20A has a redundant configuration with the generation tank 20B. Thus, as in the case of the generation tank 20A, sulfuric acid (H₂SO₄) is circulated between the generation tank 20B and the electrolytic cell 21B via the circulation pipe 130 to generate a treatment liquid containing electrolytic sulfuric acid.

To the generation tank 20B, sulfuric acid is appropriately supplied from the sulfuric acid supply source 16 by the control of the valve 16B by the control unit 90. Pure water (DIW), or the like, is appropriately supplied from the pure water supply source 14 by the control of the valve 14B by the control unit 90. Further, the treated liquid is supplied to the generation tank 20B from the collection tank 30A or the collection tank 30B by the control of the valve 126B by the control unit 90.

The temperature of the treatment liquid stored in the generation tank 20B is adjusted to an electrolysis temperature (for example, equal to or lower than 60°C) by the heater 150 and the heat exchanger 150A in the circulation pipe 130 in a state where the valve 130A is opened, particles, and the like, are appropriately removed by the filter 152, and the treatment liquid is fed to the electrolytic cell 21B by the pump 148. Heat may be generated during the electrolytic treatment (electrolysis) in the electrolytic cell 21B, and thus, the heat exchanger 150A is preferably provided in order to adjust the temperature of the treatment liquid to equal to or lower than 60°C.

Then, sulfuric acid whose temperature has been adjusted in the electrolytic cell 21B is electrolyzed to generate a treatment liquid containing electrolytic sulfuric acid and sulfuric acid. The concentration of the treatment liquid containing electrolytic sulfuric acid is measured by the concentration meter 146, and the control unit 90 adjusts the flow rate of the treatment liquid to be fed to the electrolytic cell 21B by the control of opening and closing of the valve 130A based on the measured concentration.

The generation tank 20A and the generation tank 20B can supply the treatment liquid to the supply tank 10 in a switchable manner. For example, as illustrated in the example in FIG. 8, while the valve 128A is opened to circulate the treatment liquid in the circulation pipe 128, the valve 132A is opened to supply the treatment liquid from the generation tank 20A to the supply tank 10, and during this time, the treated liquid from the collection tank 30A or the collection tank 30B can be stored in the generation tank 20B by closing the valve 130A and the valve 134A. Alternatively, in a case where the concentration of the electrolytic sulfuric acid stored in the generation tank 20A does not reach the desired concentration, by closing the valve 132A while opening the valve 128A to continue circulation of the treatment liquid in the circulation pipe 128 to increase the concentration of the treatment liquid by electrolysis of sulfuric acid and opening the valve 130A and the valve 134A, the treatment liquid reaching the desired concentration circulated in the circulation pipe 130 can be supplied from the generation tank 20B to the supply tank 10. In other words, even while the treatment liquid is being generated in one generation tank (electrolytic cell), the treatment liquid can be continuously supplied from the other generation tank.

The temperature of the treatment liquid supplied from any (or both) generation tank is adjusted to, for example, equal to or lower than 60°C by the heater 156 in the supply pipe 100, particles, and the like, are appropriately removed by the filter 158, and the treatment liquid is fed to the supply tank 10 by the pump 154 via the valve 100A in the open state.

The collection tank 30A and the collection tank 30B can supply the supplied liquid to the generation tank 20A or the generation tank 20B in a switchable manner. For example, as illustrated in the example in FIG. 8, while the valve 124A is closed to stop the supplied liquid to be supplied to the collection tank 30A, the valve 127A is opened to supply the supplied liquid from the collection tank 30A to the generation tank 20A or the generation tank 20B, and during this time, the supplied liquid can be stored in the collection tank 30B by opening the valve 124B and closing the valve 127B.

The supply tank 10 stores the treatment liquid supplied from the generation tank via the supply pipe 100. Further, pure water (DIW), or the like, is appropriately supplied from the pure water supply source 12 to the supply tank 10, so that the concentration of the treatment liquid is adjusted.

The temperature of the treatment liquid to be fed from the supply tank 10 through the circulation pipe 102 is adjusted by the heater 116 and the heat exchanger 116A such that the temperature measured by the thermometer 117 in the circulation pipe 102 is, for example, equal to or lower than 60°C, particles, and the like, are appropriately removed by the filter 119, and the treatment liquid is fed again to the supply tank 10 by the pump 114. Heat may be generated during the electrolytic treatment (electrolysis) in the electrolytic cell 118, and thus, the heat exchanger 116A is preferably provided in order to adjust the temperature of the treatment liquid to equal to or lower than 60°C. The control unit 90 grasps the substrate treatment to be performed by the treatment unit 600A with reference to the treatment recipe, and adjusts the flow rate of the treatment liquid circulating in the circulation pipe 102 by opening and closing the valve 102A, or the like, so that the flow rate of the treatment liquid measured by the flow meter 112 becomes a flow rate sufficient for the substrate treatment.

Here, the heater 116 may increase the temperature of the treatment liquid to a temperature (referred to as a circulation temperature) higher than an electrolysis temperature (equal to or lower than 60°C), which is a temperature suitable for generating electrolytic sulfuric acid. This makes is possible to reduce a temperature range when the temperature of the treatment liquid is indirectly increased to the temperature for the substrate treatment (treatment temperature) by the heater 252 that heats the substrate W in the treatment unit 600A, so that high temperature increasing performance is unnecessary for the heater 252. This improves a degree of freedom in setting of the heater 252. Note that the circulation temperature is, for example, 80°C at which a rate of autolysis of electrolytic sulfuric acid is assumed to be sufficiently low.

The measurement pipe 104 branching from the circulation pipe 102 is provided with the valve 104A and the concentration meter 120. The control unit 90 performs control such as opening the valve 12A to supply pure water, or the like, from the pure water supply source 12 to the supply tank 10, or electrolysis of the treatment liquid in the electrolytic cell 118 to increase the concentration of the treatment liquid with reference to the concentration of the treatment liquid measured by the concentration meter 120.

On the downstream side of the circulation pipe 102, the supply pipe 106 branching into each treatment unit 600A is provided. Then, by opening the corresponding valve 106A under the control of the control unit 90, it is possible to appropriately supply the treatment liquid to the treatment unit 600A while circulating the treatment liquid in the circulation pipe 102.

In the circulation state of the discharge nozzle 106B, the valve 106A and the valve 109A are opened, the valve 110A is closed, and the treatment liquid supplied from the circulation pipe 102 to the supply pipe 106 and further to the circulation pipe 109 returns to the circulation pipe 102. As described above, the treatment liquid flows into the discharge nozzle 106B in the supply pipe 106 and circulates, whereby the temperature change of the treatment liquid due to a temperature difference between the pipe and the treatment liquid can be suppressed when the treatment liquid is discharged to perform the substrate treatment. Note that in the circulation state, the collection pipe 110 does not have to be provided.

In the collection state of the discharge nozzle 106B, the valve 106A and the valve 110A are opened, the valve 109A is closed, and the treatment liquid supplied from the circulation pipe 102 to the supply pipe 106 and further to the collection pipe 110 joins the waste liquid pipe 122 and collected in the collection tank 30A or the collection tank 30B. As described above, the treatment liquid maintained at a relatively low temperature (equal to or lower than 60°C) is collected in the collection tank 30A or the collection tank 30B, whereby the treatment liquid is mixed with the treated liquid collected at a high temperature by the substrate treatment in the discharge state described later so that the treatment liquid in the collection tank 30A or the collection tank 30B can be cooled.

In the discharge state of the discharge nozzle 106B, the valve 106A is opened while the valve 109A and the valve 110A are closed, and the treatment liquid is discharged from the discharge port 31 of the discharge nozzle 106B toward the upper surface of the substrate W. Then, substrate treatment is performed.

In this event, the substrate W is heated in advance by the heater 252. Thus, the treatment liquid (electrolytic sulfuric acid) discharged onto the upper surface of the substrate W is also heated, and the temperature increases to a temperature for substrate treatment (treatment temperature).

The treatment liquid discharged to the substrate W and used for substrate treatment in a heated state flows as a treated liquid into the waste liquid pipe 122 through the valve 122A in an open state. The treated liquid contains sulfate ions (SO₄²⁻). Then, the treated liquid joins the collection pipe 124 and is collected in the collection tank 30A or the collection tank 30B. As described above, by bringing the discharge nozzle 106B into the collection state in this event, the treatment liquid maintained at a relatively low temperature (equal to or lower than 60°C) can also be collected in the collection tank 30A or the collection tank 30B, mixed with the treated liquid collected at a high temperature, and cooled in the collection tank 30A or the collection tank 30B.

The electrolytic sulfuric acid can be used again for substrate treatment by being collected and electrolyzed again. Thus, by performing the substrate treatment using the treatment liquid containing the electrolytic sulfuric acid, the waste liquid in association with the substrate treatment can be reduced.

The treated liquid stored in the collection tank 30A or the collection tank 30B can be selectively (that is, to one or both) fed to the generation tank 20A by opening the valve 126A and to the generation tank 20B by opening the valve 126B via the collection pipe 126 by the pump 136.

### <Effects Obtained by Embodiments Described Above>

Next, an example of effects obtained by the embodiments described above will be described. Note that, in the following description, the effects will be described based on the specific configurations exemplified in the embodiments described above, but may be replaced with other specific configurations exemplified in the present specification as long as similar effects are obtained. In other words, in the following description, for convenience, only one of the associated specific configurations may be described as a representative, but the specific configuration described as a representative may be replaced with another specific configuration associated.

According to the preferred embodiments described above, the substrate treatment device includes the substrate treatment unit, the supply tank 10, the generation unit, the collection unit, the circulation path, and the first branch path. Here, the substrate treatment unit corresponds to, for example, the treatment unit 600 (or the treatment unit 600A) including the discharge nozzle 106B. Further, the generation unit corresponds to, for example, the generation tank 20A (or the generation tank 20B) connected to the electrolytic cell. Still further, the collection unit corresponds to, for example, the collection pipe 124 connected to the collection tank 30A or the collection tank 30B. Yet further, the circulation path corresponds to, for example, the circulation pipe 102. Further, the first branch path corresponds to, for example, the supply pipe 106. The substrate treatment unit treats the substrate W using a treatment liquid containing electrolytic sulfuric acid. The supply tank 10 stores a treatment liquid to be supplied to the substrate treatment unit. The generation unit generates a treatment liquid by electrolysis. Then, the generation unit supplies the generated treatment liquid to the supply tank 10. The collection pipe 124 collects the supplied liquid, which is the treatment liquid having been supplied to the substrate treatment unit, and supplies the supplied liquid to the generation unit. The circulation pipe 102 returns the treatment liquid supplied from the supply tank 10 to the supply tank 10. The supply pipe 106 branches from the circulation pipe 102 and supplies the treatment liquid to the substrate treatment unit.

According to such a configuration, the generated treatment liquid containing the electrolytic sulfuric acid is stored in the supply tank 10, and the treatment liquid is supplied from the branch path to the substrate treatment unit at the time of substrate treatment while being circulated in the circulation path, so that the treatment liquid can be used for substrate treatment at necessary timing while being maintained in a uniform state. It is therefore possible to perform uniform substrate treatment.

Note that, even in a case where another component exemplified in the present specification is appropriately added to the above components, that is, even in a case where another component not mentioned as the above components in the present specification is appropriately added, a similar effect can be obtained.

Further, according to the embodiments described above, the substrate treatment device includes a temperature increasing unit provided in the supply pipe 106 for increasing the temperature of the supplied liquid. Here, the temperature increasing unit corresponds to, for example, the heater 106C or the heater 252. According to such a configuration, the heater 106C is provided in the supply pipe 106 branching from the circulation pipe 102, so that it is possible to increase the temperature of only the treatment liquid supplied to the supply pipe 106 for use in substrate treatment in the treatment unit 600 to the treatment temperature immediately before the substrate treatment while maintaining the treatment liquid circulating in the circulation pipe 102 at a relatively low temperature (equal to or lower than 60°C). Thus, the flow rate of the treatment liquid maintained at a high temperature is reduced, so that it is possible to reduce power consumption of the heater, or the like. In addition, it is possible to suppress autolysis of the electrolytic sulfuric acid in association with temperature increase and to suppress decrease in oxidizing power of the electrolytic sulfuric acid.

Further, according to the embodiments described above, the substrate treatment device includes a second branch path for branching from the supply pipe 106 and supplying the supplied liquid to the collection pipe 124. Here, the second branch path corresponds to, for example, the collection pipe 108. Then, the heater 106C is provided upstream of a point (for example, the valve chamber 40A in FIG. 4) at which the collection pipe 108 branches, in the supply pipe 106. According to such a configuration, the treatment liquid flows into the discharge nozzle 106B in the supply pipe 106 and is collected, so that it is possible to suppress a temperature change of the treatment liquid due to a temperature difference between the pipe and the treatment liquid when the treatment liquid is discharged to perform the substrate treatment. In addition, by not returning the treatment liquid in a heated state to the circulation pipe 102, it is possible to prevent the temperature increase of the treatment liquid in the circulation pipe 102 and suppress autolysis.

Further, according to the embodiments described above, the generation unit includes a first temperature adjustment unit for adjusting temperatures of the supplied liquid and the generated treatment liquid to an electrolysis temperature which is a temperature for generating the treatment liquid by electrolysis. Here, the first temperature adjustment unit corresponds to, for example, the heater 142, the heat exchanger 142A, the heater 150, the heat exchanger 150A, or the like. According to such a configuration, the supplied liquid or the treatment liquid can be supplied to the electrolytic cell while maintaining the electrolysis temperature, so that it is possible to increase generation efficiency of electrolytic sulfuric acid. In addition, autolysis of electrolytic sulfuric acid can also be suppressed.

Further, according to the embodiments described above, the substrate treatment device includes a second temperature adjustment unit for adjusting the temperature of the treatment liquid to the circulation temperature that is higher than the electrolysis temperature in the circulation pipe 102. Here, the second temperature adjustment unit corresponds to, for example, the heater 116 or the heat exchanger 116A. Then, the heater 106C or the heater 252 increases the temperature of the supplied liquid to a temperature higher than the circulation temperature. According to such a configuration, by increasing the temperature of the treatment liquid to the circulation temperature in advance by the heater 116 before increasing the temperature of the supplied liquid by the heater 106C or the heater 252, the temperature increase of the treatment liquid in the temperature increasing unit can be suppressed. Thus, even in a case where the temperature increasing performance in the temperature increasing unit is not sufficient, the temperature of the supplied liquid can be appropriately increased to the temperature (treatment temperature) at the time of being used for substrate treatment.

Further, according to the embodiments described above, the treatment unit 600A includes a substrate holding unit for holding the substrate W. Here, the substrate holding unit corresponds to, for example, the spin chuck 251. Then, the heater 252 is provided on the spin chuck 251. According to such a configuration, the treatment liquid on the upper surface of the substrate W can also be heated in association with the heating of the substrate W, so that it is not necessary to separately provide a step for increasing the temperature of the treatment liquid. In addition, the temperature of the treatment liquid can be increased immediately before the substrate treatment, so that a period during which the electrolytic sulfuric acid can be maintained at a low temperature becomes long, and deactivation of the electrolytic sulfuric acid can be suppressed. In addition, the temperature of the treatment liquid is increased downstream of a position where the circulation pipe 109 branches from the supply pipe 106, so that the treatment liquid flowing through the circulation pipe 109 can be maintained at a low temperature.

Further, according to the embodiments described above, the collection pipe 124 collects the treatment liquid before being heated by the heater 252. According to such a configuration, by collecting the treatment liquid whose temperature has not been increased, the treatment liquid can be mixed with the collected treated liquid and effectively cooled.

Further, according to the embodiments described above, the substrate treatment device includes the electrolytic cell 118 for generating a treatment liquid by electrolysis in the circulation pipe 102. According to such a configuration, by providing the electrolytic cell 118 also in the circulation pipe 102, it is possible to maintain constant concentration of the electrolytic sulfuric acid during circulation and contribute to uniform substrate treatment.

According to the embodiments described above, in the substrate treatment method, the treatment liquid containing the electrolytic sulfuric acid stored in the supply tank 10 is supplied to the substrate treatment unit for treating the substrate W using the treatment liquid. Then, the supplied liquid which is the treatment liquid having been supplied to the substrate treatment unit is collected and supplied to the generation unit. Then, the treatment liquid is generated from the liquid containing the supplied liquid by electrolysis in the generation unit, and the generated treatment liquid is supplied to the supply tank 10. Here, the step of supplying the treatment liquid to the substrate treatment unit is a step of supplying the treatment liquid to the substrate treatment unit by supplying the treatment liquid to the circulation pipe 102 for returning the treatment liquid supplied from the supply tank 10 to the supply tank 10 and the supply pipe 106 that branches from the circulation pipe 102 and supplies the treatment liquid to the substrate treatment unit.

According to such a configuration, the generated treatment liquid containing the electrolytic sulfuric acid is stored in the supply tank 10, and the treatment liquid is supplied from the branch path to the substrate treatment unit at the time of substrate treatment while being circulated in the circulation path, so that the treatment liquid can be used for substrate treatment at necessary timing while being maintained in a uniform state. It is therefore possible to perform uniform substrate treatment.

Note that, in a case where there is no particular limitation, the order in which each treatment is performed can be changed.

In addition, even in a case where another component exemplified in the present specification is appropriately added to the above components, that is, even in a case where another component not mentioned as the above components in the present specification is appropriately added, the same effect can be obtained.

### <Modifications of Embodiments Described Above>

In the embodiments described above, a material, a dimension, a shape, a relative arrangement relationship, an implementation condition, or the like, of each component may also be described, but these are one example in all aspects and are not restrictive.

Thus, innumerable modifications and equivalents in which no examples are indicated are assumed within the scope of the technology disclosed in the present specification. For example, a case where at least one component is modified includes a case where the component is added or omitted.

In addition, in at least one embodiment described above, in a case where a material name, or the like, is described without being particularly specified, unless inconsistency arises, the material includes other additives, for example, an alloy, or the like.

### EXPLANATION OF REFERENCE SIGNS

1: substrate treatment device
10: supply tank
21A: electrolytic cell
21B: electrolytic cell
118: electrolytic cell

## Claims

1. A substrate treatment device comprising:
a substrate treatment unit that treats a substrate using a treatment liquid containing electrolytic sulfuric acid;
a supply tank that stores said treatment liquid to be supplied to said substrate treatment unit;
a generation unit that generates said treatment liquid by electrolysis and supplies said generated treatment liquid to said supply tank;
a collection unit that collects a supplied liquid that is said treatment liquid having been supplied to said substrate treatment unit and supplies the supplied liquid to said generation unit;
a circulation path that returns said treatment liquid supplied from said supply tank to said supply tank;
a first branch path that branches from said circulation path and supplies said treatment liquid to said substrate treatment unit; and
a temperature increasing unit that increases a temperature of said supplied liquid.

2. The substrate treatment device according to claim 1, wherein said temperature increasing unit is provided in said first branch path.

3. The substrate treatment device according to claim 2, further comprising
a second branch path that branches from said first branch path and supplies said supplied liquid to said collection unit, wherein
said temperature increasing unit is provided upstream of a point at which said second branch path branches, in said first branch path.

4. The substrate treatment device according to any one of claims 1 to 3, wherein said generation unit includes a first temperature adjustment unit that adjusts temperatures of said supplied liquid and said generated treatment liquid to an electrolysis temperature that is a temperature for generating said treatment liquid by electrolysis.

5. The substrate treatment device according to claim 4, further comprising
a second temperature adjustment unit that adjusts the temperature of said treatment liquid to a circulation temperature that is higher than said electrolysis temperature in said circulation path, wherein
said temperature increasing unit increases the temperature of said supplied liquid to a temperature higher than said circulation temperature.

6. The substrate treatment device according to any one of claims 1 to 5, further comprising an electrolytic cell that generates said treatment liquid by electrolysis in said circulation path.

7. The substrate treatment device according to any one of claims 1 to 6, wherein
said substrate treatment unit includes a substrate holding unit that holds said substrate, and
said temperature increasing unit is provided in said substrate holding unit.

8. The substrate treatment device according to any one of claims 1 to 7, wherein said collection unit collects said treatment liquid before a temperature of said treatment liquid is increased by said temperature increasing unit.

9. A substrate treatment method of treating a substrate using a treatment liquid containing electrolytic sulfuric acid, the substrate treatment method comprising:
a step of supplying said treatment liquid stored in a supply tank to a substrate treatment unit that treats said substrate using said treatment liquid;
a step of increasing a temperature of a supplied liquid that is said treatment liquid having been supplied to said substrate treatment unit;
a step of collecting said supplied liquid and supplying said supplied liquid to a generation unit; and
a step of generating said treatment liquid from a liquid containing said supplied liquid by electrolysis in said generation unit and supplying the generated treatment liquid to said supply tank, wherein
the step of supplying said treatment liquid to said substrate treatment unit includes a step of supplying said treatment liquid to said substrate treatment unit by supplying said treatment liquid to a circulation path that returns said treatment liquid supplied from said supply tank to said supply tank and a first branch path that branches from said circulation path and supplies said treatment liquid to said substrate treatment unit.
